# EUROPEAN PATENT APPLICATION

(11) **EP 4 611 017 A1**
(43) Date of publication of application: **03.09.2025**
(21) Application number: 23959054.0
(22) Date of filing: 25.12.2023
(51) Int. Cl.: H01H 47/00

(54) **SECURITY RELAY**

(71) Applicant: System Design Corporation, Fukui-shi, Fukui 918-8104 (JP)
(72) Inventor: IIDA, Mitsuhiro, Fukui-shi, Fukui 918-8104 (JP); FUKUGI, Shigeo, Fukui-shi, Fukui 918-8104 (JP)
(74) Representative: Hamann, Jean-Christophe
(86) International application number: PCT/JP2023/046369
(87) International publication number: WO 2025/141634

(57) **Abstract**

Problem: To provide a security relay exhibiting security capability that enables control of current supply to a connected external circuit in accordance with presence / absence of a relay energization-permitted instruction from outside.

Solution: A security relay for controlling, based on a signal from outside, whether or not energization of an external circuit is permissible, which security relay comprises a control unit adapted to receive and analyze a signal from outside and to determine based on the analysis result whether or not to permit energization of the external circuit, and a power supply unit for supplying power to the control unit, wherein the control unit is configured to comprise a receiving unit for receiving signals transmitted from an external device and is adapted to perform energization processing based on permissibility of energization of the external circuit determined by reception and analysis by the receiving unit of an energization request signal from the external device.

## Description

### TECHNICAL FIELD

The present invention relates to a relay, more particularly to a security relay exhibiting security capability that enables control of current supply to a connected external circuit in accordance with presence / absence of a relay energization-permitted instruction from outside.

### BACKGROUND ART

Many variously enhanced relays have been devised and put to use and relays providing various different functions have been developed and utilized. A relay is a device triggered by application of current to some terminal of an apparatus to control passage of current to another terminal side and, for example, is a device used to ensure safety and dependable operation when passing high current. Recent years have seen the emergence of security relays that offer security functions in addition to current control capability.

A technology related to a relay equipped with various functions is found in Japanese Patent Publication No. 1996-168162A, for example. This publication discloses technology related to a multifunction protection relay that integrally incorporates switching control and other switch control functions; protection functions such as ground fault protection and overcurrent protection; voltage, current and other measurement functions; and sequencing and other transfer functions vis-a-vis a host controller, and that is adapted for use with a switch comprising memory means for storing control data, input means for inputting data, data communication means for communicating with the exterior, and memory control means for controlling writing of control data in accordance with a mode instructed by instruction means.

Although the disclosed technology does indeed enable provision of a relay capable of many functions, it cannot be considered an adequate technology from the viewpoint of security, because, for example, it is incapable of dealing with abnormal situations such as unauthorized opening / closing of the contact device or unauthorized operation of an exterior circuit that the relay is connected to.

The security capability of a relay is an important aspect of its ability to prevent energization and eliminate risk of unauthorized use. Owing to their ability to protect against unauthorized operation, devices that utilize relays, including automobile electronic components, are viewed as offering effective functions from the viewpoint of crime prevention. This has led to a desire for the development of a security relay that exhibits security capability for controlling energization of an external circuit in accordance with presence/absence of a relay energization-permitted instruction from the outside.

### PRIOR ART DOCUMENTS

### Patent Document

Patent Document 1: Japanese Patent Publication No. 1996-168162A

### DISCLOSURE OF THE INVENTION

### Problem to be Overcome by the Invention

The present invention is directed to providing a security relay for solving the aforesaid issue, particularly to a security relay exhibiting security capability that enables control of current supply to a connected external circuit in accordance with presence / absence of a relay energization-permitted instruction from the outside.

### Means for Solving the Problem

In order to achieve the aforesaid object, the security relay according to the present invention is configured as a security relay for controlling, based on a signal from outside, whether or not energization of an external circuit is permissible, which security relay comprises a control unit adapted to receive and analyze a signal from outside and to determine based on the analysis result whether or not to permit energization of the external circuit and a power supply unit for supplying power to the control unit, wherein the control unit is configured to comprise a receiving unit for receiving signals transmitted from an external device and is adapted to perform energization processing based on permissibility of energization of the external circuit determined by reception and analysis by the receiving unit of an energization request signal from the external device.

In another aspect, the security relay is a contact relay comprising an electromagnetic unit having an electromagnet, and a contact unit responsive to energization of the electromagnet for making and breaking contact between a movable contact and fixed contacts, wherein the control unit is responsive to reception and analysis by the receiving unit of an energization request signal from the external device, for performing energization processing to put the external circuit in energized state and supply current to the electromagnetic unit, the power supply unit is configured for connection both to relay terminals on the electromagnetic unit side and to relay terminals of the contact unit, and, for securing power for the control unit, a configuration is adopted wherein, when the relay terminals on the electromagnet unit side are de-energized, power acquired from the relay terminals on the contact unit side is supplied as power for implementing the control function of the control unit, and when the relay terminals on the electromagnet unit side are energized, power acquired from the relay terminals on the electromagnetic unit side is supplied as power for implementing the control function of the control unit.

In another aspect, the security relay is a semiconductor relay equipped with an input unit that produces instructions in response to input signals and an output unit that operates in response to instructions produced by the input unit, the control unit is responsive to reception and analysis by the receiving unit of an energization request signal from the external device, for performing energization processing to put the external circuit in energized state and supply current to the input unit, the power supply unit is configured for connection both to the relay terminals on the input unit side and to the relay terminals of the output unit, and a configuration is adopted for securing power for the control unit whereby, when the relay terminals on the input unit side are de-energized, power acquired from the relay terminals on the output unit side is supplied as power for implementing the control function of the control unit, and when the relay terminals on the input unit side are energized, power acquired from the relay terminals on the input unit side is supplied as power for implementing the control function of the control unit.

In another aspect, the security relay is a transformer-coupled relay equipped with an input unit that receives input signals and an output unit that operates in response to signals received by the input unit, the control unit is responsive to reception and analysis by the receiving unit of an energization request signal from the external device, for performing energization processing to put the external circuit in energized state and supply current to the input unit, the power supply unit is configured for connection both to relay terminals on the input unit side and to relay terminals of the output unit, and, for securing power for the control unit, a configuration is adopted wherein, when the relay terminals on the input unit side are de-energized, power acquired from the relay terminals on the output unit side is supplied as power for implementing the control function of the control unit, and when the relay terminals on the input unit side are energized, power acquired from the relay terminals on the input unit side is supplied as power for implementing the control function of the control unit.

In another aspect, the external circuit comprises a circuit for performing current control by means of a fuse or a switch and the security relay is configured to control whether or not to permit passage of current between terminals of the fuse or across the switch.

In another aspect, the security relay comprises monitoring means for detecting extraction of the external circuit by detecting voltage fluctuation of the external circuit.

### EFECTS OF THE INVENTION

Since the present invention is configured as described in detail in the foregoing, it has the following effects:
1. The provision of the control unit in the security relay makes it possible to ensure security by enabling energization permissibility control of the external circuit based on signals received by the control unit. In addition, the provision of the power supply unit makes it possible to freely switch and supply power to the control unit, whereby power can be supplied to the control unit without fail.
2. As the security relay can be structured basically as a contact relay, energization control can be performed using a cost-minimized control unit of simple structure. In addition, power can be secured by switching between the electromagnetic unit side and the contact unit side as power sources.
3. As the security relay can be structured basically as a semiconductor relay, it becomes possible to provide a small, high-speed and pressure-resistant relay with security capability that offers longer, failure-free service life than one of mechanical type.
4. As the security relay can be structured basically as a transformer-coupled relay, it becomes possible to provide a relay with security capability that offers long, failure-free service life.
5. As the external circuit can be a fuse or a switch, it becomes possible during operation control of an automobile or the like to ensure security in the absence of a signal received from an authorized external device by preventing energization / operation, not only through the relay but also through the fuse or the like.
6. As the security relay can be provided with monitoring means, occurrence of an unauthorized act with respect to the external circuit can be easily detected, thereby ensuring still more robust security.

### BEST MODE FOR WORKING THE INVENTION

There now follows a detailed explanation of the security relay according to the present invention, based on embodiments shown in the drawings. FIG. 1 is a conceptual diagram of the security relay according to the present invention and FIG. 2 is a conceptual diagram of a mechanical security relay. FIG. 3 is a conceptual diagram of a security relay comprising a semiconductor relay and FIG. 4 is a conceptual diagram of a security relay comprising a transformer-coupled relay.

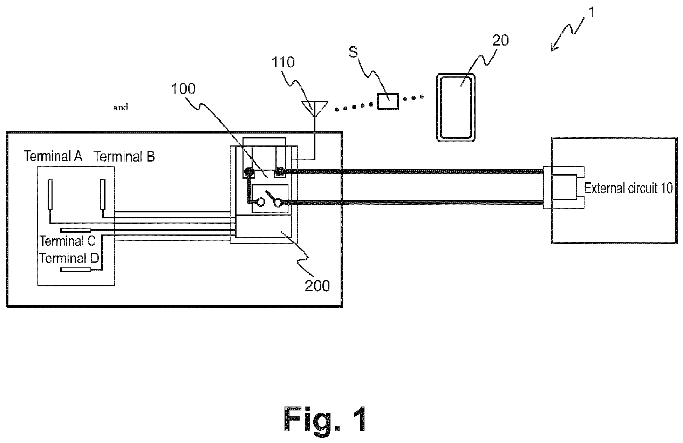

As shown in FIG. 1, a security relay 1 of the present invention is a relay equipped with a control unit 100 and a power supply unit 200, the basic structure of the relay being selectable from among mechanical type, semiconductor type and transformer-coupled type, and the security relay 1 incorporating security capability for controlling permissibility of current supply to a connected external circuit in accordance with a signal, such as a relay energization-permitted instruction signal, from outside.

The control unit 100 is a member for receiving a signal S from outside and upon analyzing the received signal S determining based on the analysis result whether or not to permit energization of an external circuit 10 connected to the security relay 1. As shown in Fig. 1, the security relay 1 is connected to the external circuit 10. The control unit 100 analyzes whether or not the received signal S is a certifiable signal and when it finds it to be certifiable commences supply of energizing current to the connected external circuit 10. In other words, the configuration is such that an electronic or other device equipped with the external circuit 10 to which the security relay 1 is connected cannot be activated if the signal S cannot be certified, whereby security can be maintained.

The power supply unit 200 is a member for supplying power to the control unit 100. In this embodiment, as power for the control 100, power from a relay terminal described later is selectable or switchable as a power source for the control unit 100.

In the present embodiment, as shown in FIG. 1, the power supply unit 200 is connected both to input side terminals (terminal A and terminal B) and to output side terminals (terminal C and terminal D) of the security relay. When the terminals on the input side are de-energized, the power supply unit 200 supplies power acquired from the terminals on the output side as power for implementing the control function of the control unit 100. As this power is weak, it has no effect on an electronic device or the like to which the external circuit 10 controlled by the security relay 1 is connected.

When the input side terminals (the terminal A and the terminal B) are energized, power cannot be obtained from the output side terminals. The power supply unit 200 therefore supplies power for implementing the control function of the control unit 100 by using power acquired from the input side terminals. Adopting this configuration ensures that the power source of the control unit 100 can be switched to enable reliable supply of power to the control unit 100. A detailed description of the power supply unit 200 operation is set out later in the following.

In the present embodiment, as indicated in FIG. 1, the control unit 100 is equipped with a receiver unit 110. The receiver unit 110 is adapted to receive signals transmitted by an external device 20 with communication capability, such as a smartphone or smart key. Upon receiving and analyzing an energization request signal from the external device 20, the receiver unit 110 determines whether or not to permit energization of the external circuit 10. The configuration is such that once the energization request signal from the external device 20 has been certified, the control unit 100 implements control for energizing the external circuit 10.

In the present embodiment, communication between the control unit 100 and the external device 20 is performed by means of Bluetooth (Registered Trademark) encrypted communication, using a configuration that establishes authentication / communication between the control unit 100 and the external device 20 by pairing, but this is not a limitation and it is of course possible to use Wi-Fi or some other communication protocol.

Owing to the aforesaid configuration, a person who does not have an authenticated smart key or authenticated smartphone is prevented from communicating with the automobile concerned when, for example, attempting to unlock / lock the vehicle lock or start its engine, thus making it possible to realize an arrangement that prevents internal energization of the automobile and therefore totally prevents the automobile from being moved, whereby vehicle theft prevention and other aspects of vehicle security can be easily achieved. Moreover, even if activation of the relay should be achieved by tampering with the security relay 1 itself, energization of the external circuit 10 connected to the security relay 1 will not be activated, thus making vehicle operation impossible and ensuring a still higher degree of security. The aforesaid configuration is capable of achieving robust security, namely can achieve a level of security that ensures that the external circuit 10 cannot be energized and activated in the absence of a signal from an authenticated external device 20.

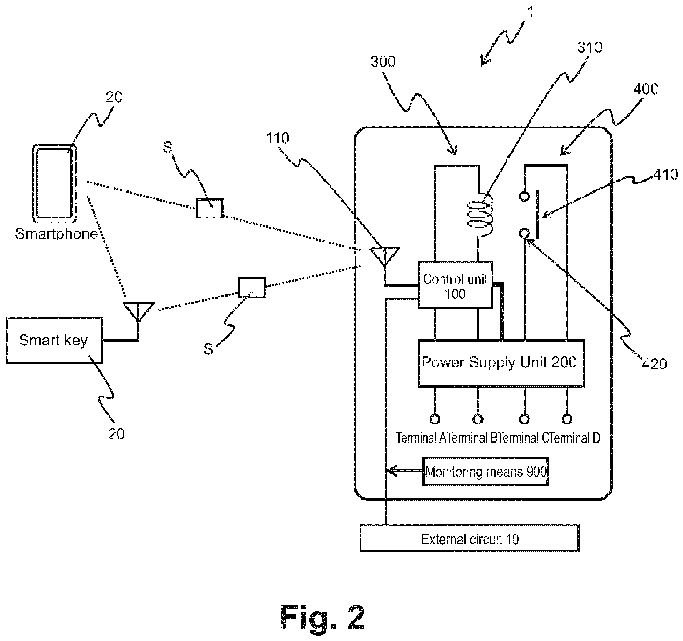

Next, an embodiment of the security relay 1 will be explained. As shown in FIG. 2, in terms of relay structure, the security relay 1 of the present invention can adopt a contact relay configuration. The present embodiment adopts a contact relay structure comprising an electromagnet unit 300 having an electromagnet 310 and a contact unit 400 responsive to energization state of the electromagnet 310, for making and breaking contact between a movable contact 410 and fixed contacts 420.

More specifically, the electromagnetic unit 300 is a member for switching energization / de-energization on the contact unit 400 side and, as shown in FIG. 1, is provided with the coil-equipped electromagnet 310. The electromagnet 310 is installed between the terminals on the electromagnetic unit 300 side (terminal A and terminal B) and generates magnetic force when current is passed between these terminals.

The contact unit 400 is a member for supplying power to connected electronic equipment, and in this embodiment, is equipped with the movable contact 410 and the fixed contacts 420, as shown in FIG. 1. Magnetic force generated by passage of current through the electromagnet 310 of the electromagnetic unit 300 brings the movable contact 410 into contact with the fixed contacts 420, whereby the contact unit 400 side terminals (terminal C and terminal D) are energized to supply power to the electronic equipment. When power to the electromagnet 300 is cut off, contact between the movable contact 410 and the fixed contacts 420 is released, the terminals C and D are de-energized, and supply of power to the electronic equipment is cut off.

The control unit 100 is responsive to reception and analysis by the receiver unit 110 of an energization request signal from the external device 20, for putting the external circuit 10 in energized state and performing power processing for energizing the electromagnetic unit 300.

As shown in FIG. 2, the power supply unit 200 is configured for connection both to the relay terminals (terminal A and terminal B) on the electromagnetic unit 300 side and to the relay terminals (terminal C and terminal D) of the contact unit 400. When the relay terminals on the electromagnet unit 300 side are de-energized, power is acquired from the relay terminals on the contact unit 400 side and the acquired power is supplied to the control unit 100 as power for implementing control functions. And when the relay terminals on the electromagnet unit 300 side are energized, power is acquired from the relay terminals on the electromagnetic unit 300 side and the acquired power is supplied to the control unit 100 as power for implementing control functions. This configuration ensures security by guaranteeing a reliable source of power for the control unit 100.

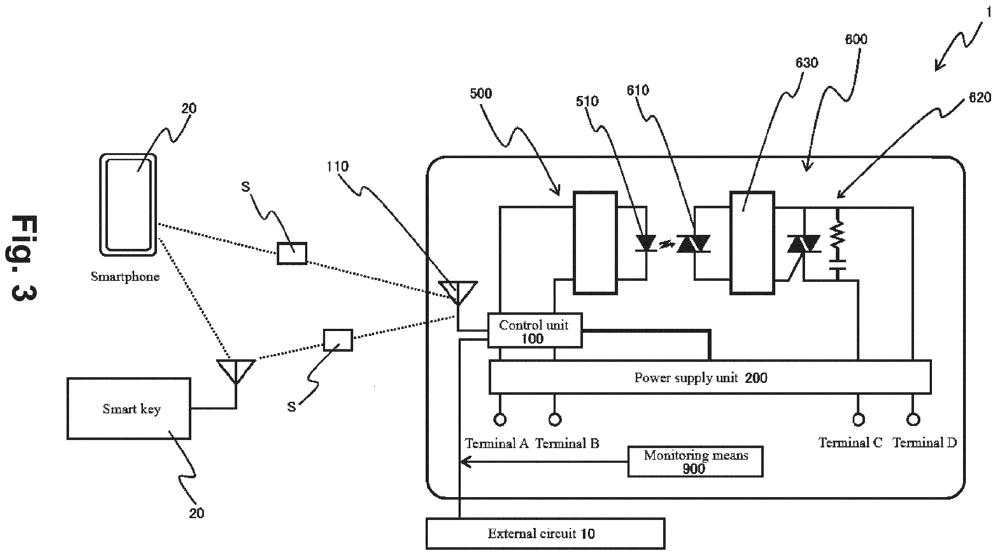

As shown in FIG. 3, the security relay 1 according to this invention can adopt a semiconductor relay as its relay structure. In such an embodiment, the configuration comprises a semiconductor relay equipped with an input unit 500 that produces instructions in response to input signals and an output unit 600 that operates in response to instructions produced by the input unit 500.

More specifically, the input unit 500 serves as a member for switching energization / de-energization on the output unit 600 side and can, as in an embodiment shown in FIG. 3, be configured as an input circuit comprising a light-emitting element 510. In this embodiment, the light-emitting element 510 is an LED that emits an optical signal when energized.

The output unit 600 is a member for supplying power to the electronic equipment equipped with the security relay 1 of the present invention and in the present embodiment can, as shown in FIG. 3, for example, be configured to comprise a photodetector 610. Upon energization, the light-emitting element 510 of the input unit 500 transmits an optical signal, which optical signal is sensed by the photodetector 610, whereby current passes to drive a drive circuit 630 to thereby enable energization of an output circuit 620, thus energizing the output unit 600 side terminals (terminals C and D) and supplying power to the electronic equipment. Moreover, when supply of power to the input unit 500 is cut off, the optical signal from the light-emitting element 510 is aborted, energization of the terminals C and D is discontinued, and supply of power to the electronic equipment is terminated.

Alternatively, the input unit 500 and the output unit 600 of the semiconductor relay of the security relay 1 according to the present embodiment can be configured using a solid-state relay (SSR). And as the light emitting element 510 and the photodetector 610 use of a suitable configuration can be selected from among, for example, a combination of photocouplers, phototriacs, LEDs and photodiode arrays. And a configuration can be adopted whose drive circuit 630 comprises a zero cross circuit and a trigger circuit. Further, a thyristor or triac, MOSFET or the like can be suitably selected for use as the output circuit 620 of the output unit 600. In addition, selection of a configuration that does not employ the light emitting element 510 and the photodetector 610 is of course also possible.

The control unit 100 is responsive to reception and analysis by the receiver unit 110 of an energization request signal from the external device 20, for putting the external circuit 10 in energized state and performing power processing for energizing the input unit 500.

As shown in FIG. 3, the power supply unit 200 is configured for connection both to the relay terminals (terminal A and terminal B) on the input unit 500 side and to the relay terminals (terminal C and terminal D) of the output unit 600. When the relay terminals on the input unit 500 side are de-energized, power is acquired from the relay terminals on the output unit 600 side and the acquired power is supplied to the control unit 100 as power for implementing control functions. And when the relay terminals on the input unit 500 side are energized, power is acquired from the relay terminals on the input unit 500 side and the acquired power is supplied to the control unit 100 as power for implementing control functions. This configuration ensures security by guaranteeing a reliable source of power for the control unit 100.

By adopting the aforesaid semiconductor relay structure as the relay structure of the security relay 1 according to the present invention, it becomes possible, in comparison to a mechanical structure, to achieve longer service life and longer-term avoidance of unusable situations due to relay malfunction. And, owing to the rapid operation achieved, it becomes possible to provide a security-capable security relay 1 offering high-speed operation. In addition, the downsizing to the security relay 1 that can be realized enhances its convenience by minimizing restriction on place of installation.

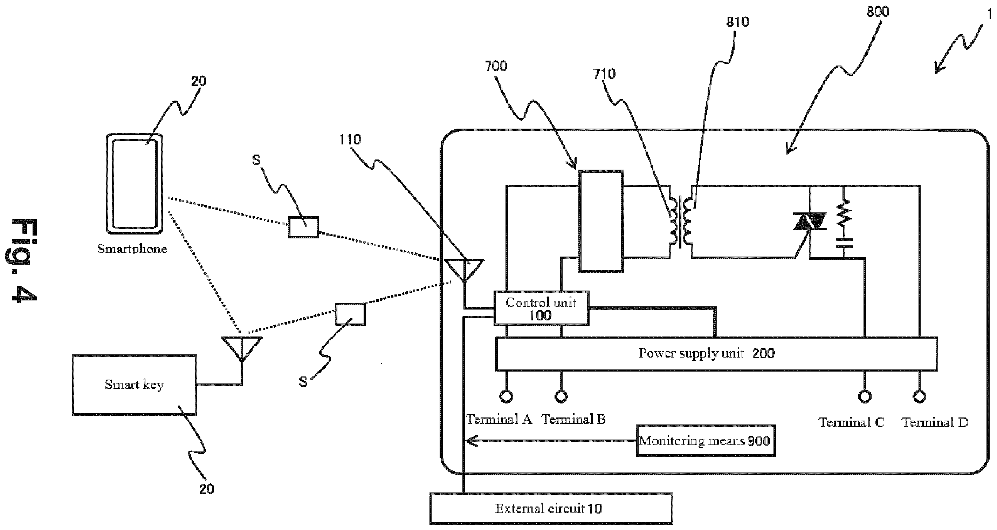

As per another embodiment of the security relay 1 according to the present invention, illustrated in FIG. 4, a transformer-coupled relay can be selected as the relay structure. In this embodiment, the transformer-coupled relay comprises an input unit 700 for receiving input signals and an output unit 800 that operates in response to signals received from the input unit 700.

More specifically, the input unit 700 serves as a member for switching energization / de-energization on the output unit 800 side and in the present embodiment can, as shown in FIG. 4, comprise a transformer primary winding 710 as a relay component. The output unit 800 is a member for supplying power to the electronic equipment equipped with the security relay 1 of the present invention, and in the present embodiment is, as shown in Fig. 4, equipped with a transformer secondary winding 810 as a relay component.

In other words, passage of current through the primary coil 710 of the transformer produces electromagnetic induction that causes current flow in the secondary winding 810. As a result, current induced on the output unit 800 side energizes the output unit 800 side terminals (terminal C and terminal D) and supplies power to the electronic equipment. Moreover, the configuration is such that when supply of power to the input unit 700 is cut off, flow of secondary coil 810 current stops owing to loss of the electromagnetic induction effect, whereby energization across the terminals C and D discontinues and supply of power to the electronic equipment stops. In the present embodiment, the input unit 700 and output unit 800 constituting the security relay 1 are transformer components and the primary winding 710 and secondary coil 810 are wound around an iron core (not shown).

The control unit 100 is responsive to reception and analysis by the receiver unit 110 of an energization request signal from the external device 20, for putting the external circuit 10 in energized state and performing power processing for energizing the input unit 700.

As shown in FIG. 4, the power supply unit 200 is configured to connect both to the relay terminals (terminal A and terminal B) on the input unit 700 side and to the relay terminals (terminal C and D) on the output unit 800 side. When the relay terminals on the input unit 700 side are de-energized, power is acquired from the relay terminals on the output unit 800 side and the acquired power is supplied to the control unit 100 as power for implementing control functions. And when the relay terminals on the input unit 700 side are energized, power is acquired from the relay terminals on the input unit 700 side and the acquired power is supplied to the control unit 100 as power for implementing control functions. This configuration ensures security by guaranteeing a reliable source of power for the control unit 100.

By adopting the aforesaid transformer-coupled relay structure as the relay structure of the security relay 1 according to the present invention, it becomes possible, in comparison to a mechanical structure, to achieve longer service life and longer-term avoidance of unusable situations due to relay malfunction, whereby a highly convenient security relay 1 can be provided.

In this embodiment, the external circuit 20 is a circuit that performs current control by means of a fuse or switch. In other words, the security relay 1 according to this invention is configured to control whether or not to permit passage of current between terminals of the fuse or across the switch. The adoption of this configuration makes it possible during operation control of an automobile or the like to ensure security in the absence of a signal received from an authorized external device by preventing energization / operation, not only through the relay but also through the fuse or the like. In other words, once power has been acquired from the relay terminals, control other than relay control becomes possible, thereby ensuring adequate security.

As shown in FIGs. 2 to 4, the security relay 1 according to the present invention can be configured to include monitoring means 900. The monitoring means 900 detects voltage fluctuation of the external circuit 10 to which the security relay 1 is connected and controls. This makes it possible to detect detachment, unauthorized operation and the like of the external circuit 10. When this configuration is adopted, occurrence of an unauthorized act with respect to the external circuit 10 can be easily detected, thereby ensuring still stronger security.

The security relay 1 according to the present invention is not limited to the aforesaid use in automobiles but can be applied in equipment of any kind, including machine tools, home appliances and building locking / unlocking systems. Moreover, it enables security capability enhancement simply by replacing existing relays.

### BRIEF EXPLANATION OF THE DRAWINGS

FIG. 1 is a conceptual diagram of the security relay according to the present invention.
FIG. 2 is a conceptual diagram of a mechanical security relay.
FIG. 3 is a conceptual diagram of a security relay comprising a semiconductor relay.
FIG. 4 is a conceptual diagram of a security relay comprising a transformer-coupled relay.

### EXPLANATION OF SYMBOLS

- 1: Security relay
- S: Signal
- 10: External circuit
- 20: External device
- 100: Control unit
- 110: Receiver unit
- 200: Power supply unit
- 300: Electromagnetic unit
- 310: Electromagnet
- 400: Contact unit
- 410: Movable contact
- 420: Fixed contact
- 500: Input unit
- 510: Light-emitting element
- 600: Output unit
- 610: Photodetector
- 620: Output circuit
- 630: Drive circuit
- 700: Input unit
- 710: Primary winding
- 800: Output unit
- 810: Secondary winding
- 900: Monitoring means

## Claims

1. In a security relay for controlling, based on a signal from outside, whether or not energization of an external circuit (10) is permissible,
a security relay (1) **characterized in** comprising:
a control unit (100) adapted to receive and analyze a signal from outside and after analyzing the received signal to determine based on the analysis result whether or not to permit energization of the external circuit; and
a power supply unit (200) for supplying power to the control unit (100),
wherein the control unit (100) comprises a receiving unit (110) for receiving signals transmitted from an external device (20) and is adapted to perform energization processing based on permissibility of energization of the external circuit (10) determined by reception and analysis by the receiving unit (110) of an energization request signal from the external device (20).

2. A security relay according to claim 1, **characterized in that** the security relay (1) is a contact relay comprising an electromagnetic unit (300) having an electromagnet (310), and a contact unit (400) responsive to energization of the electromagnet for making and breaking contact between a movable contact (410) and fixed contacts (420), wherein
the control unit (100) is responsive to reception and analysis by the receiving unit (110) of an energization request signal from the external device (20), for performing energization processing to put the external circuit (10) in energized state and supply current to the electromagnetic unit (300), and
the power supply unit (200) is configured for connection both to relay terminals on the electromagnetic unit (300) side and to relay terminals of the contact unit (400), and, for securing power for the control unit (100), a configuration is adopted wherein, when the relay terminals on the electromagnet unit (300) side are de-energized, power acquired from the relay terminals on the contact unit (400) side is supplied as power for implementing the control function of the control unit (100), and when the relay terminals on the electromagnet unit (300) side are energized, power acquired from the relay terminals on the electromagnetic unit (300) side is supplied as power for implementing the control function of the control unit (100).

3. A security relay according to claim 1, **characterized in that**:
the security relay (1) is a semiconductor relay equipped with an input unit (500) that produces instructions in response to input signals and an output unit (600) that operates in response to instructions produced by the input unit (500);
the control unit (100) is responsive to reception and analysis by the receiving unit (110) of an energization request signal from the external device (20), for performing energization processing to put the external circuit (10) in energized state and supply current to the input unit (500);
the power supply (200) unit is configured for connection both to relay terminals on the input unit (500) side and to relay terminals of the output unit (600); and
a configuration is adopted for securing power for the control unit (100) whereby, when the relay terminals on the input unit (500) side are de-energized, power acquired from the relay terminals on the output unit (600) side is supplied as power for implementing the control function of the control unit (100), and when the relay terminals on the input unit (500) side are energized, power acquired from the relay terminals on the input unit (500) side is supplied as power for implementing the control function of the control unit (100).

4. A security relay according to claim 1, **characterized in that** the security relay (1) is a transformer-coupled relay equipped with an input unit (700) that receives input signals and an output unit (800) that operates in response to signals received by the input unit (700), wherein
the control unit (100) is responsive to reception and analysis by the receiving unit (110) of an energization request signal from the external device (20), for performing energization processing to put the external circuit (10) in energized state and supply current to the input unit (700);
the power supply unit (200) is configured for connection both to relay terminals on the input unit (700) side and to relay terminals of the output unit (800); and
a configuration is adopted for securing power for the control unit (100) whereby, when the relay terminals on the input unit (700) side are de-energized, power acquired from the relay terminals on the output unit (800) side is supplied as power for implementing the control function of the control unit (100), and when the relay terminals on the input unit (700) side are energized, power acquired from the relay terminals on the input unit (700) side is supplied as power for implementing the control function of the control unit (100).

5. A security relay according to any of claims 2 to 4, **characterized in that** the external circuit (20) comprises a circuit for performing current control by means of a fuse or a switch and the security relay (1) is configured to control whether or not to permit passage of current between terminals of the fuse or across the switch.

6. A security relay according to any of claims 1 to 5, **characterized in that** the security relay (1) comprises monitoring means (900) for detecting extraction of the external circuit (10) by detecting voltage fluctuation of the external circuit (10).
